# FASCICULE DE BREVET EUROPEEN

(11) **EP 3 283 292 B1**
(45) Date de publication et mention de la délivrance du brevet: **08.05.2019**
(21) Numéro de dépôt: 16719242.6
(22) Date de dépôt: 11.04.2016
(51) Int. Cl.: B32B 9/00, B32B 15/00, C23C 16/26, C23C 14/06

(54) **PROCÉDÉ DE PRÉPARATION D'UNE PIÈCE MÉTALLIQUE EN VUE DE L'AMÉLIORATION DE LA MESURE DE SA TEMPÉRATURE PAR PYROMÉTRIE OPTIQUE LORS DE SA MISE EN PRESSION DANS DES CONDITIONS DE DÉFORMATION UNIAXIALE**
VERFAHREN ZUR HERSTELLUNG EINES METALLISCHEN TEILS ZUR VERBESSERUNG DER MESSUNG DER TEMPERATUR DAVON DURCH OPTISCHE PYROMETRIE WÄHREND DER UNTERDRUCKSETZUNG DAVON UNTER EINACHSIGEN VERFORMUNGSBEDINGUNGEN
METHOD FOR PREPARING A METALLIC PART IN SUCH A WAY AS TO IMPROVE THE MEASUREMENT OF THE TEMPERATURE OF SAME BY OPTICAL PYROMETRY DURING PRESSURISATION OF SAME UNDER UNIAXIAL DEFORMATION CONDITIONS

(30) Priorité: 13.04.2015 FR 1553196
(43) Date de publication de la demande: 21.02.2018
(73) Titulaire: Commissariat à l'Énergie Atomique et aux Énergies Alternatives, 75015 Paris (FR)
(72) Inventeur: BOUCHKOUR, Zakaria, 45400 Fleury Les Aubrais (FR); CHAUVIN, Camille, 46120 Leyme (FR); SINATTI, Frédéric, 46120 Leyme (FR)
(74) Mandataire: Brevalex
(86) Numéro de dépôt international: PCT/EP2016/057904
(87) Numéro de publication internationale: WO 2016/166053

(56) Documents cités:
- EP-A1- 0 795 622
- EP-A1- 1 338 576
- WO-A1-2007/020139
- WO-A1-2009/080610
- WO-A1-2013/075061
- JP-A- H02 143 912
- US-A1- 2007 104 953
- Camille Chauvin: "Contribution la mesure de température des matériaux sous choc modéré par pyrométrie optique", , 30 avril 2010 (2010-04-30), pages 1-215, XP055237324, Extrait de l'Internet: URL:https://tel.archives-ouvertes.fr/tel-0 0477899/document [extrait le 2015-12-17]

## Description

### DOMAINE TECHNIQUE

Le domaine de l'invention est celui de la mesure de la température par pyrométrie optique de pièces métalliques mises en pression dans des conditions de déformations uniaxiales, par exemple de type choc ou de type compression isentropique.

On s'intéresse en particulier à un revêtement multicouche particulier qui va permettre d'améliorer la précision de la mesure de la température sur de telles pièces.

### ÉTAT DE LA TECHNIQUE ANTÉRIEURE

Dans le cadre de la présente invention, on s'intéresse à la mesure de la température d'une pièce métallique soumise à une sollicitation dynamique mécanique particulière lorsque celle-ci est mise sous pression dans des conditions de déformation uniaxiale. Il peut s'agir par exemple d'essais d'impacts plan (sollicitations dynamiques par choc) ou encore d'essais de type compression isentropique.

Lors d'une mesure de température d'une pièce métallique par pyrométrie optique, la température est déduite du rayonnement infrarouge émis par la pièce. Or, la méconnaissance de l'émissivité du matériau de la pièce considérée introduit la principale source d'incertitude sur la mesure de la température et la technique de mesure elle-même ne suffit pas pour s'affranchir complètement de la méconnaissance de ce paramètre.

Plusieurs travaux ont été réalisés pour tenter de réduire l'influence de ce paramètre sur les mesures de température, soit en mesurant l'émissivité du matériau lors de l'expérience, en la calculant à partir des luminances mesurées par les pyromètres, en l'encadrant ou bien encore en augmentant l'émissivité apparente de la surface de la pièce.

Des chercheurs ont tenté par le passé d'allier ces deux dernières solutions en augmentant l'émissivité apparente de la surface de la pièce, en permettant ainsi de réduire l'incertitude sur la température en procédant à un encadrement plus précis de l'émissivité. L'émissivité apparente de la pièce est augmentée par l'application d'un revêtement dont l'émissivité est élevée, imitant ainsi l'émission d'un corps noir. Cette méthode a été mise en oeuvre dans les travaux de Perez (documents **[1]** et **[2]**), en utilisant des revêtements de platine (Pt) ou de siliciure de rhénium (ReSi₂) pour obtenir des émissivités allant jusqu'à 0,8.

La principale difficulté de cette technique est d'obtenir un revêtement qui soit opaque, afin de cacher le rayonnement provenant de la pièce sous-jacente, et qui soit fin et adhérent, afin que les échanges thermiques entre la pièce et le revêtement soient suffisamment rapides par rapport au temps caractéristique de la mise en pression dans des conditions de déformation uniaxiale (allant d'une centaine de nanosecondes à quelques microsecondes).

Par ailleurs, afin de répondre aux problématiques des études sous choc ou autres sollicitations dynamiques mécaniques (compression, tension), les propriétés mécaniques et thermiques du matériau constituant le revêtement doivent être connues (notamment sa conductivité thermique et ses propriétés mécaniques sous sollicitation). Or, bon nombre de ces propriétés ne sont pas connues pour les matériaux utilisés jusqu'à présent. Le document **[3]** reflète la problématique du manque de connaissance des propriétés sous choc, en mettant en évidence les difficultés rencontrées pour réaliser des corrélations expérience/calcul lors d'expériences de mesures de températures sous choc utilisant des revêtements émissifs dont les propriétés sous sollicitation mécanique sont peu ou pas référencées. Le document [5] divulgue un procédé de préparation d'une pièce métallique selon le préambule de la revendication 1.

### EXPOSÉ DE L'INVENTION

L'invention a pour objectif d'améliorer la mesure de la température par pyrométrie optique (pyrométrie infrarouge) d'une pièce métallique mise sous pression dans des conditions de déformation uniaxiale.

A cet effet, l'invention propose un procédé de préparation d'une pièce métallique en vue de mesurer sa température par pyrométrie optique lorsque la pièce est mise sous pression dans des conditions de déformation uniaxiale de type choc ou de type compression isentropique, le procédé comprenant la formation d'un revêtement émissif sur une face de la pièce métallique et le procédé étant caractérisé en ce que le revêtement émissif a une épaisseur comprise entre 250 nm et 550 nm et comprend une première couche en carbone amorphe et une deuxième couche en carbone amorphe, la première couche étant intercalée entre la face de la pièce métallique et la deuxième couche, et ayant un taux d'hybridation en carbone sp³ supérieur au taux d'hybridation en carbone sp³ de la deuxième couche, le procédé comprenant en outre la fixation, sur le revêtement émissif, d'une fenêtre enclume.

Dans le cadre de la présente invention, un revêtement émissif est un revêtement dont la valeur d'émissivité thermique est supérieure ou égale à 0,7 dans le domaine spectral du rayonnement thermique infrarouge à détecter. En l'occurrence, la valeur d'émissivité thermique du revêtement est choisie supérieure ou égale à 0,7 dans le domaine spectral IR allant de 1,5 µm à 5,5 µm de longueur d'onde, qui est la gamme spectrale de détection du pyromètre optique utilisé.

Le revêtement émissif selon l'invention comprend une première couche et une deuxième couche, toutes deux en carbone amorphe. On rappelle que le carbone amorphe (également appelé DLC pour « Diamond-Like Carbon » en anglais) est un matériau carbone comportant des liaisons sp² et des liaisons sp³, ainsi qu'une éventuelle concentration en atomes d'hydrogènes plus ou moins importante. On peut ainsi avoir des couches en carbone amorphe non hydrogéné, de type a-C (pour « amorphous carbon » en anglais) ou de type ta-C (pour « tetrahedral amorphous carbon » en anglais) ou en carbone amorphe hydrogéné, de type a-C :H ou de type ta-C :H.

Le procédé selon l'invention comprend la fixation, sur le revêtement émissif, d'un élément particulier appelé « fenêtre enclume ». La fenêtre enclume permet de soutenir la sollicitation mécanique appliquée sur la pièce métallique (au moins pendant la durée pendant laquelle la contrainte désirée est appliquée à la pièce étudiée ainsi qu'à son revêtement), évitant ainsi la mise à pression ambiante de la pièce, tout en maintenant mécaniquement ladite pièce. La fixation de cet élément sur le revêtement peut être obtenue à l'aide d'une fine couche de colle, choisie de sorte qu'elle ne perturbe pas la mesure dans le domaine infrarouge étudié au cours de la mesure par pyrométrie optique. En d'autres termes, la colle choisie doit être transparente aux IR.

Le choix de la fenêtre enclume se fait quant à lui de sorte que le flux thermique issu de la pièce métallique et du revêtement émissif ne soit pas (ou très peu) absorbé par la fenêtre enclume dans la gamme de longueurs d'ondes du pyromètre optique utilisé : la fenêtre enclume est donc transparente dans la gamme de longueurs d'onde du pyromètre. Il pourrait, par exemple, s'agir d'un bloc de PMMA (polyméthacrylate de méthyle) ou de saphir. De préférence, on choisit un cristal de fluorure de lithium (LiF).

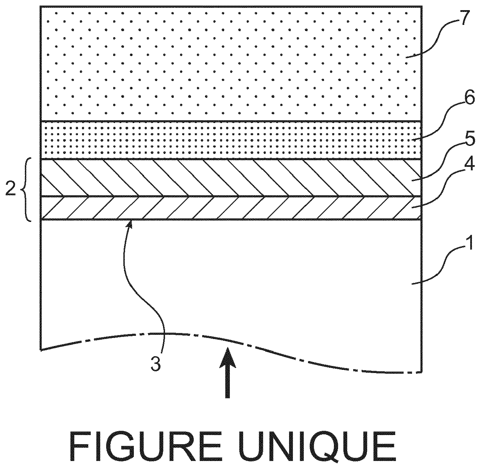

Selon un mode de réalisation préféré de l'invention, la première et la deuxième couche ont, de préférence, une teneur atomique en hydrogène inférieure à 20%, préférentiellement inférieure à 10%. Il est bien entendu que lorsqu'on parle de la teneur atomique en hydrogène d'une couche, il s'agit du nombre d'atomes d'hydrogène rapporté sur le nombre total d'atomes présent dans cette couche. On peut par exemple se référer au diagramme ternaire illustré en figure 1 du document **[4]**. Ainsi, de préférence, le carbone amorphe des première et deuxième couches est un carbone amorphe non hydrogéné. Pour minimiser la teneur en atomes d'hydrogène des couches en carbone amorphe, on peut utiliser des conditions d'élaboration des couches défavorables à l'apparition de dépôts hydrogénés : vide poussé et éviter l'utilisation de gaz contenant des atomes d'hydrogène (hydrocarbures, méthane, etc.). En l'occurrence, dans les modes de réalisation préférés qui sont décrits ci-dessous, la formation des couches en carbone amorphe a été obtenue sous vide poussé et en utilisant de l'argon comme gaz plasmagène.

L'intérêt de l'utilisation du carbone amorphe pour la première et la deuxième couche réside, d'une part, dans l'émissivité importante de ce matériau (proche du corps noir), d'autre part, dans la connaissance de ses propriétés thermiques et mécaniques sous contrainte et, enfin, dans son opacité. Au final, ces deux couches permettent d'accroitre l'émittance thermique de la pièce métallique et vont permettre d'améliorer la qualité du signal reçu par le pyromètre optique lors de la mesure de la température de la pièce métallique sous contrainte mécanique et ainsi d'augmenter la précision des simulations associées permettant le calcul de la température de la pièce.

La différence entre la teneur en hybridation sp³ de la première et de la deuxième couche est un point important dans le cadre de la présente invention. En effet, l'inventeur a constaté qu'en l'absence de la première couche, la deuxième couche avait tendance à s'écailler une fois que son épaisseur allait au-delà de 300 nm. La couche écaillée est alors altérée et impropre à une mesure de température de surface sous sollicitation dynamique mécanique : les zones écaillées montrent que le dépôt n'est plus adhérent à la pièce, provoquant ainsi un décollement et/ou des insertions d'air qui sont à l'origine de l'apparition de signaux non désirés (rayonnement parasite, artéfacts importants) lors de la mesure. Dans le cadre de l'invention, la teneur en hybridation sp³ étant plus élevée dans la première couche par rapport à la deuxième couche, on obtient une première couche plus « diamantée » et une deuxième couche plus « graphitée ». L'Inventeur suppose que la présence de la première couche facilite l'accroche de la deuxième couche, notamment par la meilleure affinité des liaisons carbone-carbone.

Selon un mode de réalisation préféré, la première couche a une épaisseur comprise entre 50 et 150 nm, de préférence égale à 100 nm, et la deuxième couche a une épaisseur comprise entre 200 et 400 nm, de préférence égale à 300 nm. De préférence, le revêtement émissif est constitué uniquement de la première et de la deuxième couche en carbone amorphe et le revêtement émissif a une épaisseur totale comprise entre 250 et 550 nm.

La bonne connaissance de l'épaisseur des couches composant le revêtement émissif étant primordiale pour les applications et ayant une influence sur le résultat final de la mesure de température de la pièce, les épaisseurs des couches ont été mesurées et vérifiées par plusieurs méthodes :
- par mesure de la hauteur d'une marche sur une face d'une pièce dont une partie comporte le revêtement émissif et dont l'autre partie reste nue (sans revêtement émissif). Cette marche est créée en cachant une partie de la face de la pièce lors de la formation du revêtement émissif. La hauteur de la marche ainsi obtenue est ensuite mesurée par deux techniques :
   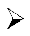 par interférométrie par balayage en lumière blanche à l'aide d'un microscope à objectifs interférométriques de Michelson, par exemple un microscope NewView™ 6200 de chez Zygo ;
   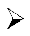 par profilométrie mécanique à l'aide d'un stylet dont la pointe est en contact avec la surface et enregistrement des déflexions de la pointe, à l'aide par exemple de l'appareil Surftest SJ401 de chez Mitutoyo.
- par observation d'une coupe transverse du revêtement émissif par microscopie électronique à balayage et mesure de l'épaisseur du revêtement observé ;
- par analyse du revêtement émissif par ellipsométrie spectroscopique donnant accès aux épaisseurs du revêtement, par exemple en utilisant un ellipsomètre UVISEL™ de chez Horiba Jobin Yvon.

Selon un mode de réalisation préféré, le procédé comprend en outre le polissage de la face de la pièce métallique jusqu'à obtenir une rugosité de surface de la face de 10 à 30 nm, le polissage étant effectué avant la formation du revêtement émissif.

Avantageusement, la formation du revêtement émissif comprend la formation de la première couche sur la face de la pièce par pulvérisation cathodique radiofréquence d'une cible de carbone.

Avantageusement, la formation du revêtement émissif comprend la formation de la deuxième couche sur la première couche par dépôt physique en phase vapeur par bombardement d'une cible de graphite par faisceau d'électrons.

L'invention concerne également un procédé de mesure, par pyrométrie optique, de la température d'une pièce métallique mise sous pression dans des conditions de déformation uniaxiale de type choc ou compression isentropique, le procédé de mesure comprenant les étapes successives suivantes :
- la préparation de la pièce métallique par la mise en oeuvre du procédé de préparation selon l'une des revendications 1 à 7 ;
- l'application, sur la pièce métallique, d'une pression dans des conditions de déformation uniaxiale de type choc ou compression isentropique ;
- la mesure de l'intensité d'un rayonnement infrarouge émis par le revêtement émissif ; et
- la conversion de l'intensité ainsi mesurée en une valeur de la température de la pièce métallique mise sous pression.

La conversion pourra se faire à partir d'une table de conversion déterminée préalablement par étalonnage du pyromètre optique.

La température du revêtement émissif est en équilibre thermique avec celle de la pièce métallique sous pression ; la conversion de l'intensité du rayonnement infrarouge émis par le revêtement permet donc de déduire la température de la pièce métallique sous-jacente.

L'avantage de la première et de la deuxième couche en carbone amorphe selon l'invention est qu'elles peuvent être facilement et rapidement réalisées. Le procédé de préparation de la pièce est ainsi simple à mettre en oeuvre et peu coûteux. En outre, selon un mode particulier de réalisation, les première et deuxième couches peuvent être réalisées au sein d'une même enceinte réactionnelle de dépôt physique en phase vapeur (PVD pour « Physical Vapor Déposition » en anglais) avec un réacteur équipé de l'une et l'autre des deux technologies de dépôts PVD utilisées pour réaliser la première et la deuxième couche (pulvérisation cathodique radiofréquence d'une cible de carbone pour la première couche et bombardement d'une cible de graphite par faisceau d'électrons pour la deuxième couche).

D'autres caractéristiques et avantages de l'invention apparaîtront mieux à la lecture du complément de description qui suit et qui se réfère à la figure unique annexée.

Bien entendu, ce complément de description n'est donné qu'à titre d'illustration de l'invention et ne constitue en aucun cas une limitation de celle-ci.

### BRÈVE DESCRIPTION DE LA FIGURE

La figure unique représente une vue schématique en coupe longitudinale de l'architecture de l'ensemble formé par la pièce métallique, le revêtement multicouche et l'élément « fenêtre enclume » selon un mode de réalisation possible de l'invention. La flèche illustre la direction de propagation de la mise sous pression de la pièce dans des conditions de déformations uniaxiale.

### EXPOSÉ DÉTAILLÉ DE MODES DE RÉALISATION PARTICULIERS

Afin d'illustrer le procédé de préparation objet de l'invention, nous allons à présent décrire un exemple de préparation d'une pièce métallique selon l'invention.

La pièce métallique que nous allons utiliser dans cet exemple est un disque en cuivre, ayant un diamètre de 40 mm et une épaisseur de 4 mm.

Il est préférable de réaliser un polissage de la surface de la pièce métallique destinée à recevoir le revêtement multicouche, de manière à obtenir une rugosité moyenne comprise entre 10 et 30 nm. Ce polissage permet de faciliter l'accroche du revêtement multicouche. Il permet également d'éviter la présence de toute rugosité de surface pouvant être le site de création de points chauds, dans le cas d'expérimentations sous choc, perturbant la mesure de température de la pièce.

Le polissage peut par exemple être réalisé en utilisant une polisseuse rotative équipée successivement avec des disques abrasifs ayant une rugosité de plus en plus fine, et avec des disques feutrés sur lesquels sont pulvérisés des suspensions diamantées pour réaliser un polissage de finition.

Nous avons présenté dans le tableau ci-dessous la gamme de disques abrasifs et de disques feutrés que nous avons utilisée, ainsi que leurs paramètres d'utilisation.

| Type d'abrasif | Durée (minutes) | Force de pression (N) | Vitesse de rotation de l'abrasif (tours/minute) |
|---|---|---|---|
| Disque SiC 1200 | 2 | 25 | 220 |
| Disque SiC 2400 | 2 | 25 | 220 |
| Disque SiC 4000 | 2 | 25 | 220 |
| Suspension diamantée 3 µm | 2 | 25 | 220 |
| Suspension diamantée 3 µm | 2 | 20 | 190 |

Ce polissage est suivi d'un nettoyage, par exemple à l'aide d'un mélange d'éthanol et d'acétone, puis d'un séchage de la pièce, par exemple par air comprimé ou gaz inerte comprimé, si l'on craint d'obtenir une oxydation superficielle de la pièce.

Selon l'épaisseur du revêtement émissif que l'on souhaite obtenir et le type de pièce à revêtir, les épaisseurs des première et deuxième couches en carbone amorphe vont être adaptées.

Dans cet exemple de réalisation, on réalise une première couche en carbone amorphe d'une épaisseur de 100 nm par pulvérisation cathodique radiofréquence (RFPVD pour « RadioFrequency Physical Vapor Déposition » en anglais ou « RF sputtering ») d'une cible de carbone. Le dépôt est réalisé dans une enceinte réactionnelle de dépôt physique en phase vapeur et les paramètres de dépôt sont par exemple :
- nature du gaz plasmagène : argon
- puissance RF : 75 W
- pression de travail : 1.10⁻¹ mbar
- distance cible de carbone/substrat : 2,5 cm
- durée : 5 minutes.

On réalise ensuite, sur cette première couche, une deuxième couche en carbone amorphe d'une épaisseur de 300 nm. On obtient un dépôt opaque de couleur noire. Cette deuxième couche est par exemple réalisée par dépôt physique en phase vapeur par faisceau d'électrons (EBPVD pour « Electron Beam Physical Vapor Déposition » en anglais) dans la même enceinte réactionnelle de PVD utilisée pour réaliser la première couche. Les paramètres de dépôt sont par exemple :
- puissance du canon à électrons : 900 W
- pression de travail : 5.10⁻⁵ mbar
- distance source de carbone/substrat : 15 cm
- durée : 30 minutes.

L'épaisseur du revêtement multicouche est ainsi de 400 nm.

Nous avons effectué une analyse semi-quantitative XPS (pour « X-ray Photoelectron Spectroscopy » en anglais) de la première et de la deuxième couche afin de quantifier leur teneur en hybridation sp³. Nous avons obtenu une teneur de 35% en hybridation sp³ et 65% en hybridation sp² pour la première couche et une teneur de 30% en hybridation sp³ et 70% en hybridation sp² pour la deuxième couche.

Une couche de colle est ensuite déposée sur le revêtement multicouche et permet de fixer, sur le revêtement, un élément dit « fenêtre enclume ».

La couche de colle et la fenêtre enclume sont choisies de manière à ce qu'elles soient transparentes dans la gamme de longueurs d'ondes (IR) captées par le pyromètre optique que l'on souhaite utiliser. En effet, il ne faut pas que le flux thermique issu de la pièce métallique soit en grande partie absorbé par la couche de colle ou par la fenêtre enclume, afin que la mesure réalisée soit exploitable et qu'elle corresponde à la température issue de la pièce métallique avec le revêtement.

On peut par exemple utiliser une résine issue d'un mélange d'Araldite™ AY 103-1 et d'Aradur™ HY 951 à 10% pour fixer la fenêtre enclume sur le revêtement et un cristal de fluorure de lithium, d'une épaisseur comprise entre 10 et 20 mm, comme fenêtre enclume.

Dans notre exemple de réalisation, on dépose une couche de résine de 10 µm d'épaisseur sur le revêtement et, dans un délai compris entre 5 et 60 secondes, on dispose sur cette résine, alors qu'elle est encore liquide (avant sa polymérisation), le cristal de fluorure de lithium : la colle encore liquide se répand alors sur toute la surface commune entre la pièce revêtue et le cristal LiF. On applique ensuite une pression de 2 kg pendant une durée comprise entre 8 et 12 heures sur le cristal, afin d'obtenir une épaisseur finale de colle inférieure à 10 micromètres sur l'ensemble de la surface collée.

Dans la figure unique est représentée la pièce métallique ainsi préparée : la pièce métallique 1 comporte, sur l'une de ses faces 3, un revêtement multicouche 2 constitué ici d'une première couche de carbone amorphe 4 et d'une deuxième couche de carbone amorphe 5, une couche de colle 6 et un élément 7 qui va servir de fenêtre enclume. Dans cette figure, la direction de la sollicitation mécanique dynamique est appliquée sur la face inférieure de la pièce métallique 1 et est symbolisée par la flèche.

### REFERENCES CITEES

**[1]** Perez M. « Residual temperature measurements of shocked copper and iron plates by infrared pyrometry », Shock Waves of Condensed Matter 1991, (1992), p. 737-740.
**[2]** Perez M. « Pyrométrie infrarouge de précision pour la mesure de température post-choc de matériaux métalliques dans la gamme 70 - 1000°C », Journal de Physique IV, Colloque C3, supplément au Journal de Physique III, vol. 1, (1991), pp 371 - 378.
**[3]** Chauvin C. et al. « An application of the emissive layer technique to temperature measurement by infrared optical pyrometer », Shock Compression of Condensed Matter 2011, AIP Conf. Proc. 1426, (2012), pp 368-371.
**[4]** Grill A. « Diamond-like carbon: state of the art », Diamond and Related Materials, 8 (1999), pages 428-434.
**[5]** Chauvin C. « Contribution à la mesure de température des matériaux sous choc modéré par pyrométrie optique », (2010), pp 1-215, XP055237324.

## Revendications

1. Procédé de préparation d'une pièce métallique (1) en vue de mesurer sa température par pyrométrie optique lorsque la pièce est mise sous pression dans des conditions de déformation uniaxiale de type choc ou de type compression isentropique, le procédé comprenant la formation d'un revêtement émissif (2) sur une face (3) de la pièce métallique, le procédé comprenant en outre la fixation, sur le revêtement émissif (2), d'une fenêtre enclume (7), et étant **caractérisé en ce que** le revêtement émissif (2) a une épaisseur comprise entre 250 nm et 550 nm et comprend une première couche (4) en carbone amorphe et une deuxième couche (5) en carbone amorphe, la première couche étant intercalée entre la face de la pièce métallique et la deuxième couche, et ayant un taux d'hybridation en carbone sp³ supérieur au taux d'hybridation en carbone sp³ de la deuxième couche.

2. Procédé selon la revendication 1, dans lequel la première couche (4) a une épaisseur comprise entre 50 et 150 nm et la deuxième couche (5) a une épaisseur comprise entre 200 et 400 nm.

3. Procédé selon la revendication 2, dans lequel le revêtement émissif (2) est constitué uniquement de la première et de la deuxième couche en carbone amorphe.

4. Procédé selon l'une quelconque des revendications 1 à 3, dans lequel la première et la deuxième couche ont une teneur atomique en hydrogène inférieure à 20%.

5. Procédé selon l'une quelconque des revendications 1 à 4, comprenant en outre le polissage de la face (3) de la pièce métallique jusqu'à obtenir une rugosité de surface de la face de 10 à 30 nm, le polissage étant effectué avant la formation du revêtement émissif.

6. Procédé selon l'une quelconque des revendications 1 à 5, dans lequel la formation du revêtement émissif (2) comprend la formation de la première couche (4) sur la face de la pièce par pulvérisation cathodique radiofréquence d'une cible de carbone.

7. Procédé selon l'une quelconque des revendications 1 à 6, dans lequel la formation du revêtement émissif (2) comprend la formation de la deuxième couche (5) sur la première couche par dépôt physique en phase vapeur par bombardement d'une cible de graphite par faisceau d'électrons.

8. Procédé de mesure, par pyrométrie optique, de la température d'une pièce métallique (1) mise sous pression dans des conditions de déformation uniaxiale de type choc ou compression isentropique, le procédé de mesure comprenant les étapes successives suivantes :
- la préparation de la pièce métallique par la mise en oeuvre d'un procédé de préparation selon l'une quelconque des revendications 1 à 7 ;
- l'application, sur la pièce métallique, d'une pression dans des conditions de déformation uniaxiale de type choc ou compression isentropique ;
- la mesure de l'intensité d'un rayonnement infrarouge émis par le revêtement émissif ; et
- la conversion de l'intensité ainsi mesurée en une valeur de la température de la pièce métallique mise sous pression.

## Patentansprüche

1. Verfahren zur Herstellung eines metallischen Werkstücks (1) im Hinblick auf eine Messung seiner Temperatur durch optische Pyrometrie, wenn das Werkstück unter Druck gesetzt wird unter uniaxialen Verformungsbedingungen vom Typ Schock oder vom Typ isentrope Kompression, wobei das Verfahren die Bildung einer emittierenden Beschichtung (2) auf einer Fläche (3) des metallischen Werkstücks umfasst, wobei das Verfahren ferner die Befestigung eines Kontaktfensters (7) auf der emittierenden Beschichtung (2) umfasst, und **dadurch gekennzeichnet, dass** die emittierende Beschichtung (2) eine Dicke hat, die zwischen 250 nm und 550 nm enthalten ist, und eine erste Schicht (4) aus amorphem Kohlenstoff sowie eine zweite Schicht (5) aus amorphem Kohlenstoff umfasst, wobei die erste Schicht zwischen der Fläche des metallischen Werkstücks und der zweiten Schicht eingelagert ist, und eine Hybridisierungsrate von sp³-Kohlenstoff hat, die größer ist als die Hybridisierungsrate von sp³-Kohlenstoff der zweiten Schicht.

2. Verfahren nach Anspruch 1, bei dem die erste Schicht (4) eine Dicke hat, die zwischen 50 und 150 nm enthalten ist, und die zweite Schicht (5) eine Dicke hat, die zwischen 200 und 400 nm enthalten ist.

3. Verfahren nach Anspruch 2, bei dem die emittierende Beschichtung (2) ausschließlich aus der ersten und aus der zweiten Schicht aus amorphem Kohlenstoff gebildet ist.

4. Verfahren nach einem der Ansprüche 1 bis 3, bei dem die erste und die zweite Schicht einen Atomgehalt von Wasserstoff von weniger als 20% haben.

5. Verfahren nach einem der Ansprüche 1 bis 4, ferner umfassend das Polieren der Fläche (3) des metallischen Werkstücks, bis eine Oberflächenrauigkeit der Fläche von 10 bis 30 nm erhalten wird, wobei das Polieren vor der Bildung der emittierenden Beschichtung durchgeführt wird.

6. Verfahren nach einem der Ansprüche 1 bis 5, bei dem die Bildung der emittierenden Beschichtung (2) die Bildung der ersten Schicht (4) auf der Fläche des Werkstücks durch kathodische Radiofrequenzpulverisierung eines Kohlenstofftargets umfasst.

7. Verfahren nach einem der Ansprüche 1 bis 6, bei dem die Bildung der emittierenden Beschichtung (2) die Bildung der zweiten Schicht (5) auf der ersten Schicht durch physikalische Dampfphasenabscheidung mittels Sputtern eines Graphittargets mit einem Elektronenstrahl umfasst.

8. Verfahren zur Messung der Temperatur eines metallischen Werkstücks (1), das unter Druck unter uniaxialen Verformungsbedingungen von Typ Schock oder isentrope Kompression gesetzt ist, durch optische Pyrometrie, wobei das Messverfahren die folgenden aufeinanderfolgenden Schritte umfasst:
- Herstellen des metallischen Werkstücks durch Durchführung eines Herstellungsverfahrens nach einem der Ansprüche 1 bis 7;
- Ausüben eines Drucks auf das metallische Werkstück unter uniaxialen Verformungsbedingungen vom Typ Schock oder isentrope Kompression;
- Messen der Intensität einer Infrarotstrahlung, die durch die emittierende Beschichtung emittiert wird; und
- Umwandeln der derart gemessenen Intensität in einen Temperaturwert des unter Druck gesetzten metallischen Werkstücks.

## Claims

1. Method for preparing a metal part (1) so as to measure the temperature thereof by optical pyrometry when the part is put under pressure under uniaxial deformation conditions of the shock type or of the isentropic compression type, the method comprising the formation of an emissive coating (2) on a face (3) of the metal part, the method further comprising the fixing, on the emissive coating (2), of an anvil window (7), and being **characterised in that** the emissive coating (2) has a thickness of between 250 nm and 550 nm and comprises a first layer (4) of amorphous carbon and a second layer (5) of amorphous carbon, the first layer being interposed between the face of the metal part and the second layer, and having a degree of carbon hybridisation sp³ greater than the degree of carbon hybridisation sp³ of the second layer.

2. Method according to claim 1, wherein the first layer (4) has a thickness of between 50 and 150 nm and the second layer (5) has a thickness of between 200 and 400 nm.

3. Method according to claim 2, wherein the emissive coating (2) consists solely of the first and second layers of amorphous carbon.

4. Method according to any of claims 1 to 3, wherein the first and second layers have an atomic hydrogen content of less than 20%.

5. Method according to any of claims 1 to 4, further comprising the polishing of the face (3) of the metal part until a surface roughness of the face of 10 to 30 nm is obtained, the polishing being carried out before the formation of the emissive coating.

6. Method according to any of claims 1 to 5, wherein the formation of the emissive coating (2) comprises the formation of the first layer (4) on the face of the part by radiofrequency cathodic sputtering of a carbon target.

7. Method according to any of claims 1 to 6, wherein the formation of the emissive coating (2) comprises the formation of the second layer (5) on the first layer by physical vapour deposition by bombardment of a graphite target by electron beam.

8. Method for measuring, by optical pyrometry, the temperature of a metal part (1) put under pressure under uniaxial deformation conditions of the shock or isentropic compression type, the measurement method comprising the following successive steps:
- the preparation of the metal part by implementing a preparation method according to any of claims 1 to 7;
- the application, to the metal part, of a pressure under uniaxial deformation conditions of the shock or isentropic compression type;
- the measurement of the intensity of an infrared radiation emitted by the emissive coating; and
- conversion of the intensity thus measured into a value of the temperature of the metal part put under pressure.
